# EUROPEAN PATENT APPLICATION

(11) **EP 4 726 778 A1**
(43) Date of publication of application: **15.04.2026**
(21) Application number: 24306664.4
(22) Date of filing: 10.10.2024
(51) Int. Cl.: H01L 23/66, H03F 1/02, H03F 3/191

(54) **POWER AMPLIFIER DEVICE WITH INPUT-TO-OUTPUT BIAS-CONDUCTING STRUCTURE AND TRANSMITTER PLATFORM WITH SUCH A DEVICE**

(71) Applicant: NXP USA, Inc., Austin, TX 78735 (US)
(72) Inventor: Scatamacchia, Damien, 31023 Toulouse (FR); Lembeye, Olivier, 31023 Toulouse (FR)
(74) Representative: Hardingham, Christopher Mark

(57) **Abstract**

A power amplifier device (130, 230, 330, 430, 430', 530, 530') includes a power transistor die (154, 174, 454, 474), an input side signal lead (140, 141, 240, 241, 440, 441) electrically coupled to an input terminal of the power transistor die and extending beyond an input side (131, 231, 331, 431, 1031) of the device, an output side signal lead (144, 145, 244, 245, 444, 445) electrically coupled to an output terminal of the power transistor die and extending beyond an output side (132, 232, 332, 432, 1032) of the device, and an input-to-output bias-conducting structure (133, 135, 433, 435, 533, 535, 1000, 1100, 1200, 1300) that is not physically directly connected to the input side signal lead or to the output side signal lead. The input-to-output bias-conducting structure includes an input side bias lead (142, 143, 242, 243, 342, 343, 442, 443, 542, 543, 1042, 1242, 1342) coupled to an input portion of the device, an output side bias lead (146, 147, 246, 247, 346, 247, 446, 447, 546, 547, 1046, 1246, 1346) coupled to an output portion of the device, and an interior conductive structure (134, 136, 434, 436, 1034, 1134, 1234, 1334) with a first end connected to the input side bias lead, and a second end connected to the output side bias lead.

## Description

### TECHNICAL FIELD

Embodiments of the subject matter described herein relate generally to power amplifier devices that operate using bias voltages, and more particularly to such power amplifier devices included within base station transmitters.

### BACKGROUND

The Doherty power amplifier is ubiquitous within cellular base station transmitters because the Doherty power amplifier architecture is known to improve back-off efficiency for spectrally efficient modulations, when compared with other types of amplifiers. The high efficiency of the Doherty power amplifier makes the architecture desirable for current and next-generation wireless systems. However, the trends toward higher and higher operational frequencies (e.g., in the gigahertz (GHz) range) and increased system miniaturization presents challenges to conventional Doherty power amplifier architectures, particularly in the area of semiconductor package design and amplifier platform design.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a schematic diagram of transmitter system that includes a packaged power amplifier device mounted to a transmitter substrate, in accordance with an example embodiment;
FIG. 2 is a top view of a transmitter platform that includes a packaged power amplifier device with straight bias leads mounted on a transmitter substrate, in accordance with an example embodiment;
FIG. 3 is a top view of a transmitter platform that includes a packaged power amplifier device with insect-type bias leads mounted on a transmitter substrate, in accordance with an example embodiment;
FIG. 4 is a top view of a power amplifier device with straight bias leads that may be used with the transmitter system of FIG. 2, in accordance with an example embodiment;
FIG. 5 is a top view of a power amplifier device with insect-type bias leads that may be used with the transmitter system of FIG. 3, in accordance with an example embodiment;
FIG. 6 is a top view of the power amplifier device of FIG. 4 coupled to a transmitter platform with an alternate output bias circuit, in accordance with another example embodiment;
FIG. 7 is a top view of a power amplifier device of FIG. 5 coupled to a transmitter platform with an alternate output bias circuit, in accordance with another example embodiment;
FIG. 8 is a top view of a power amplifier device with straight bias leads that may be used with the transmitter system of FIG. 2, in accordance with yet another example embodiment;
FIG. 9 is a top view of a power amplifier device with insect-type bias leads that may be used with the transmitter system of FIG. 3, in accordance with yet another example embodiment;
FIG. 10 is a side-cross sectional view of a first embodiment of an input-to-output bias-conducting structure formed from multiple conductive structures;
FIG. 11 is a side-cross sectional view of a second embodiment of an input-to-output bias-conducting structure formed from multiple conductive structures and wirebonds;
FIG. 12 is a top view of a third embodiment of an input-to-output bias-conducting structure that includes straight bias leads that are integrally-formed with an interior conductive structure; and
FIG. 13 is a top view of a fourth embodiment of an input-to-output bias-conducting structure that includes insect-type bias leads that are integrally-formed with an interior conductive structure.

### DETAILED DESCRIPTION

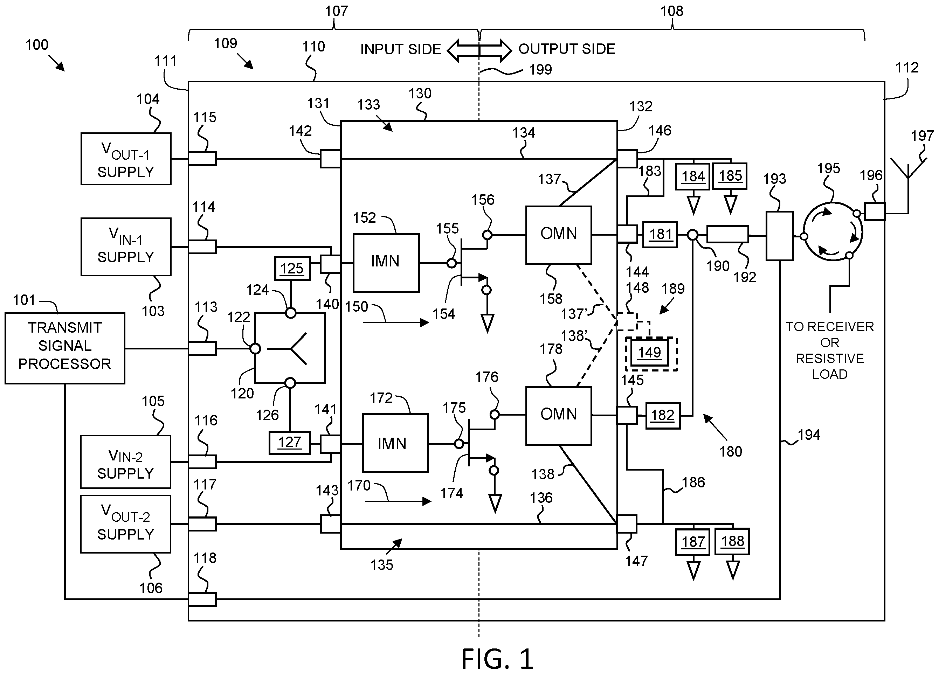

Embodiments of the inventive subject matter described herein include power amplifiers (e.g., including but not limited to Doherty power amplifiers), which are configured to amplify radio frequency (RF) signals, and which may be integrated into a transmitter platform of a cellular base station transmitter. According to one or more embodiments, a "transmitter platform" is a transmitter system (e.g., system 100, FIG. 1) that includes a transmitter substrate (e.g., substrate 110, FIG. 1), a packaged power amplifier device (e.g., device 130, FIG. 1) coupled to a mounting surface of the transmitter substrate, and additional terminals, conductive traces, and other circuitry associated with the transmitter system.

When incorporated into a cellular base station, the transmitter platform may be physically and electrically connected to a system substrate through a plurality of terminals (e.g., terminals 113-118, FIG. 1) on an input portion of the transmitter substrate. At least one of the terminals (e.g., terminal 113, FIG. 1) and associated conductive traces and circuitry may be configured to receive an input RF signal that is to be amplified, and to conduct that input RF signal to input terminals (e.g., terminals 155, 175, FIG. 1) of power transistors (e.g., transistors 154, 174, FIG. 1) within the packaged power amplifier device. At least one other terminal (e.g., bias voltage terminals 114, 116, FIG. 1) and associated conductive traces may be configured to receive input (or gate) bias voltages, and to conduct those bias voltages to the input terminals (e.g., terminals 155, 175, FIG. 1) of power transistors (e.g., transistors 154, 174, FIG. 1) within the packaged power amplifier device. Finally, at least one other terminal (e.g., bias voltage terminals 115, 117, FIG. 1) and associated conductive traces may be configured to receive output (or drain) bias voltages, and to conduct those bias voltages to output terminals (e.g., terminals 156, 176, FIG. 1) of power transistors (e.g., transistors 154, 174, FIG. 1) within the packaged power amplifier device.

According to one or more embodiments, a packaged power amplifier device includes one or more input-to-output bias-conducting structures (e.g., structures 133, 135, FIG. 1), which enable the output bias voltages to be conducted from the input portion of the transmitter substrate through the packaged power amplifier device to the output portion of the transmitter substrate (and ultimately to an output side signal lead of the packaged power amplifier device).

Conventional transmitter platforms route output bias voltages from the input portion to the output portion of a transmitter substrate through conductive traces on the transmitter substrate. The width of the transmitter substrate, thus, must be sufficient to accommodate those conductive traces on either or both sides of the packaged power amplifier device. In contrast, by routing output bias voltages from the input portion to the output portion of a transmitter substrate through the packaged power amplifier device in accordance with one or more embodiments, the overall width of the transmitter substrate may be reduced. Accordingly, embodiments of the inventive subject matter facilitate desirable reductions in transmitter substrate width and size (e.g., reductions of 30 percent or more of the area of the transmitter substrate may be achievable).

The transmitter platform embodiments described herein may house any of a variety of different types of power amplifiers. To provide a concrete example that will help to convey the details of the inventive subject matter, an example of a transmitter platform that houses a Doherty power amplifier is described herein. However, those of skill in the art will understand, based on the description herein, that the inventive subject matter may be utilized in systems and platforms that include other types of amplifiers, as well. Accordingly, the use of a Doherty power amplifier in the example embodiments below is not meant to limit application of the inventive subject matter only to Doherty power amplifiers, as the inventive subject matter may be used with other types of power amplifiers, as well.

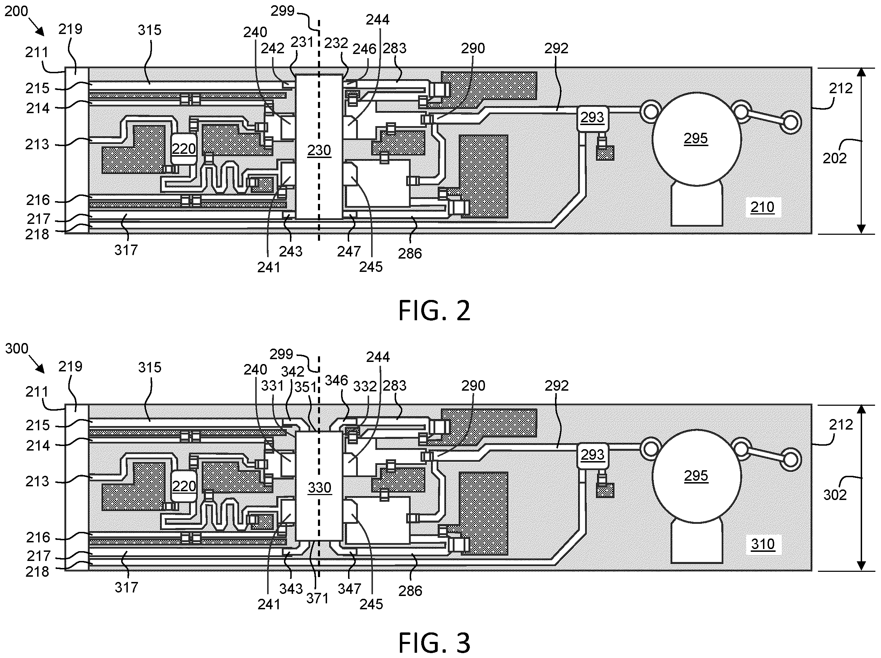

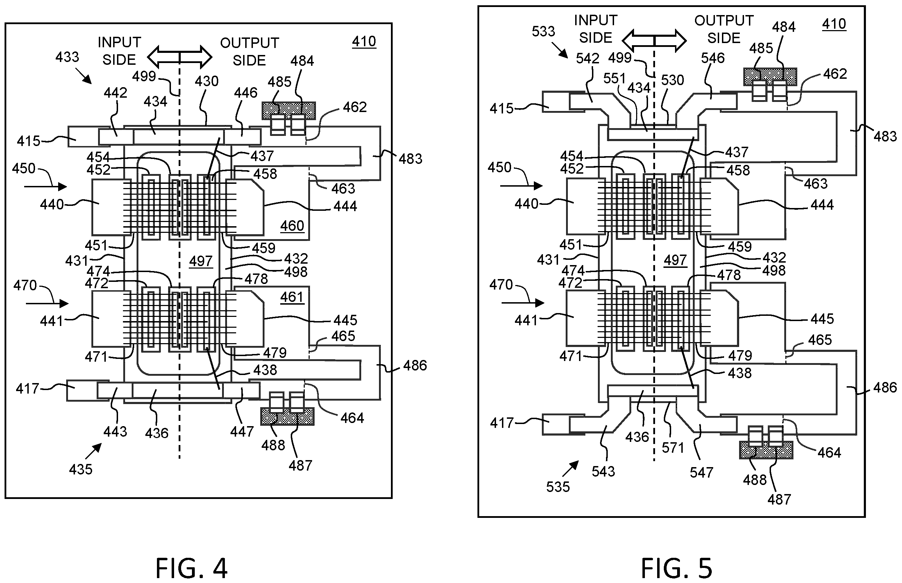

Prior to describing various physical implementations of power amplifiers and transmitter platforms, reference is made to FIG. 1, which is a schematic diagram of an example embodiment of a transmitter platform 100 that includes a Doherty power amplifier 109. The Doherty power amplifier 109 is implemented on a transmitter substrate 110 (e.g., transmitter substrate 210, 310, 410, 610, 810, FIGs 2-9). The Doherty power amplifier 109 includes circuitry that is directly coupled to the transmitter substrate 110 and circuitry disposed within a packaged power amplifier device 130 that is mounted to the transmitter substrate 110. Importantly, according to one or more embodiments, the amplification components (e.g., carrier and peaking power transistor dies 454, 474, FIGs 4-9) of the Doherty power amplifier 109 are included within the packaged power amplifier device 130, while other portions of the Doherty power amplifier 109 are disposed on the transmitter substrate 110.

The transmitter substrate 110 may include, for example, a printed circuit board (PCB) or other suitable substrate. The transmitter substrate 110 has an input side 111, an output side 112 opposite the input side, and a transmitter substrate mounting surface that extends between the input and output sides 111, 112. Further, the transmitter substrate 110 has an input portion 107 that extends from the input side 111 to a bisection line 199 between the input side 111 and the output side 112. The transmitter substrate 110 also includes an output portion 108 that extends that extends parallel to sides 111, 112 of the transmitter substrate 110, and the bisection line 199 defines the input side and output portions 107, 108 of the transmitter substrate 110. In addition, the bisection line 199 extends parallel to input and output sides 131, 132 of the power amplifier device 130, thus defining input side and output portions (not numbered) of the power amplifier device 130.

A plurality of terminals 113-118 are coupled to the input portion 107 of the transmitter substrate 110. According to one or more embodiments, the terminals 113-118 more specifically may be positioned at or proximate to the input side 111 of the transmitter substrate 110. In some embodiments, the terminals 113-118 may be configured to be connected directly to a system substrate associated with a transmitter system. In other embodiments, the terminals 113-118 may form portions of an edge connector (e.g., edge connector 219, FIGs 2, 3) at the input side 111 of the transmitter substrate 110. As will be described in more detail later, the terminals 113-118 (and edge connector, if included) enable the transmitter platform 100 to be physically and electrically connected to the other portions of a transmitter system. Accordingly, all of the input/output signals and bias voltages may be provided to the transmitter platform 100 through the terminals 113-118 at the input portion 107 of the transmitter substrate 110.

In the example of FIG. 1, for example, terminal 113 may be a signal input terminal that is configured to be electrically connected to a transmit signal processor 101. In addition, terminals 114-117 may be bias voltage terminals, which are configured to be electrically connected to various bias voltage power supplies 103-106. More specifically, bias voltage terminal 114 is configured to be connected to a first bias voltage power supply 103 that produces a first bias voltage, V_{IN-1}, for a control (input/gate) terminal of a first power transistor device (e.g., power transistor device 454, FIGs 4-9) within the power amplifier device 130. Bias voltage terminal 116 is configured to be connected to a second bias voltage power supply 105 that produces a second bias voltage, V_{IN-2}, for a control (input/gate) terminal of a second power transistor device (e.g., power transistor device 474, FIGs 4-9) within the power amplifier device 130. Bias voltage terminal 115 is configured to be connected to a third bias voltage power supply 104 that produces a third bias voltage, V_{OUT-1}, for an output (drain) terminal of the first power transistor device. Finally, bias voltage terminal 117 is configured to be connected to a fourth bias voltage power supply 106 that produces a fourth bias voltage, V_{OUT-2}, for an output (drain) terminal of the second power transistor device. In addition, the plurality of terminals also may include a feedback terminal 118, which is configured to convey a feedback signal from a power coupler 193 at the output portion 108 of the transmitter substrate 110 to the transmit signal processor 101.

The packaged power amplifier device 130 may be a discrete, surface-mountable device that is configured to be coupled to a mounting surface of the transmitter substrate 110. More particularly, distal/exterior ends of conductive device leads 140-147 (e.g., leads 240-247, 342, 343, 346, 347, 440-447, 542, 543, 546, 547, FIGs 2-9) of the packaged power amplifier device 130 are physically and electrically coupled to conductive bond pads (not numbered) at the mounting surface of the transmitter substrate 110.

The power amplifier device 130 has a package body with an input side 131, and output side 132, and transverse sides (not numbered) that extend between the input and output sides 131, 132. In addition to defining input and output portions 107, 108 of the transmitter substrate 110, the bisection line 199 also defines input and output portions (not numbered) of the power amplifier device 130. More particularly, as shown in FIG. 1, the packaged power amplifier device 130 transcends the bisection line 199, so that multiple input side leads 140-143 protruding from the input side 131 of the device 130 (and from the input portion of the device 130) are coupled to the input portion 107 of the transmitter substrate 110, and multiple output side leads 144-148 protruding from the output side 132 of the device 130 (and from the output portion of the device 130) are coupled to the output portion 108 of the transmitter substrate 110.

As indicated previously, the transmitter substrate 110 houses the Doherty power amplifier 109. According to one or more embodiments, the Doherty power amplifier 109 includes the signal input terminal 113 on the transmitter substrate 110, a power splitter 120 on the input portion 107 of the transmitter substrate 110, a carrier amplifier path 150 that extends through the packaged power amplifier device 130, a peaking amplifier path 170 that extends through the packaged power amplifier device 130, and an output combining network 180 on the output portion 108 of the transmitter substrate 110 (including a combining node 190).

When the transmitter platform 100 is incorporated into a larger RF system, the signal input terminal 113 is coupled to an RF signal source within the transmit signal processor 101. An input signal (e.g., an RF signal) is received through the signal input terminal 113. The input signal essentially is an analog signal that may, for example, include spectral energy that is centered around one or more carrier frequencies (e.g., around a fundamental frequency of operation, *ƒ₀*, and possibly one or more other frequencies). Fundamentally, the Doherty power amplifier 109 is configured to amplify the input signal received at the signal input terminal 113, and to produce an amplified output RF signal at the combining node 190. As will be described in more detail below, the amplified signal produced at the combining node 190 is conveyed through an output impedance transformer 192 on the transmitter substrate 110 to a load (e.g., an antenna 197). In some embodiments, the output impedance transformer 192 is coupled to the load through a circulator 195 and an output terminal 196. According to one or more embodiments, the output combining network 180, the output impedance transformer 192, the circulator 195, and the output terminal 196 all are coupled to the output portion 108 of the transmitter substrate 110.

Operation of the Doherty power amplifier 109 will now be described in more detail. According to an embodiment, the input RF signal received at the signal input terminal 113 is conveyed to an input 122 of the power splitter 120. The power splitter 120 is configured to divide the RF signal received at input 122 into first and second RF signals (or carrier and peaking signals), which are provided through power splitter outputs 124, 126, respectively, to first and second input side signal leads 140, 141 (or carrier and peaking signal input leads) of the power amplifier device 130. More specifically, the carrier and peaking signals are provided to the carrier and peaking amplifier paths 150, 170. According to an embodiment, the power splitter 120 is configured to impart a phase difference (e.g., about a 90 degree phase difference) between the carrier and peaking RF signals. In such an embodiment, at outputs 124 and 126, the carrier and peaking signals may be about 90 degrees out of phase from each other. Additionally or alternatively, the signal transmission paths between the power splitter outputs 124, 126 and the input side signal leads 140, 141 each may include or function as phase shifting circuits 125, 127, which impart phase delays to the carrier and peaking signals conveyed between the power splitter outputs 124, 126 and the input side signal leads 140, 141. Each of the phase shifting circuits 125, 127 may impart either a minimal delay or a significant delay to the carrier or peaking signal conveyed through the circuit to achieve the 90 degree phase difference between the carrier and peaking signals when they arrive at the input terminals 155, 175 (gate terminals) of the carrier and peaking amplifier transistors 154, 174.

When Doherty power amplifier 109 has a symmetrical configuration (i.e., a configuration in which the power transistors in dies (e.g., dies 454, 474, FIGs 4-9) are substantially identical in size), the power splitter 120 may divide or split the power of the input RF signal received at the input 122 into carrier and peaking signals that are very similar with, in some embodiments, equal power. Conversely, when Doherty power amplifier 109 has an asymmetrical configuration (e.g., a configuration in which the power transistor in the peaking amplifier die 474 (FIG. 4) is significantly larger than the power transistor in the carrier amplifier die 454 (FIG. 4)), the power splitter 120 may output carrier and peaking signals having unequal power.

Within the packaged power amplifier device 130, the first input side signal lead 140 is coupled to the carrier amplifier path 150, and the second input side signal lead 141 is coupled to the peaking amplifier path 170. As will be described in more detail below, the carrier amplifier path 150 is configured to amplify the carrier signal from the power splitter 120, resulting in an amplified carrier signal at a first output side signal lead 144. Similarly, the peaking amplifier path 170 is configured to amplify the peaking signal from the power splitter 120, resulting in an amplified peaking signal at a second output side signal lead 145.

Within the packaged power amplifier device 130, the carrier amplifier path 150 includes a carrier amplifier transistor 154 and input and output impedance matching networks 152, 158 (IMN, OMN) (also referred to as impedance matching "circuits"). The input impedance matching network 152 is coupled between the first input side signal lead 140 and an input terminal 155 (e.g., gate terminal or control terminal) of the carrier amplifier transistor 154. The output impedance matching network 158 is coupled between an output terminal 156 (e.g., drain terminal) of the carrier amplifier transistor 154 and the first output side signal lead 144.

According to one or more embodiments, a first RF low-impedance node (referred to as an "RF cold point") is present along the carrier amplifier path 150, and more particularly within the output impedance matching network 158. As used herein, an "RF low-impedance node" or "RF cold point" refers to a conductive node within a circuit (e.g., along the carrier or peaking amplifier paths 150, 170) that corresponds to a low impedance point in the circuit for RF signals. As will be explained in more detail later, the first RF cold point is a desirable node at which to supply a drain-source bias voltage to the output terminal 156 of the carrier amplifier transistor 154.

The carrier amplifier transistor 154 is configured to amplify the carrier signal received through the first input side signal lead 140 in order to produce an amplified carrier signal at the output terminal 156 (e.g., drain terminal) of the carrier amplifier transistor 154, and thus at the first output side signal lead 144.

The peaking amplifier path 170 includes a peaking amplifier transistor 174 and input and output impedance matching networks 172, 178 (IMN, OMN). The input impedance matching network 172 is coupled between the second input side signal lead 141 and an input terminal 175 (e.g., gate terminal or control terminal) of the peaking amplifier transistor 174. The output impedance matching network 178 is coupled between an output terminal 176 (e.g., drain terminal) of the peaking amplifier transistor 174 and the second output side signal lead 145.

According to one or more embodiments, a second RF low-impedance node (or second RF cold point) is present along the peaking amplifier path 170, and more particularly within the output impedance matching network 178. As will be explained in more detail later, the second RF cold point is a desirable node at which to supply a drain-source bias voltage to the output terminal 176 of the peaking amplifier transistor 174.

The peaking amplifier transistor 174 is configured to amplify the peaking signal received through the second input side signal lead 141 in order to produce an amplified peaking signal at the output terminal 176 (e.g., drain terminal) of the peaking amplifier transistor 174, and thus at the second output side signal lead 145.

Each amplifier transistor 154, 174 is implemented on a semiconductor die (e.g., power transistor dies 454, 474, FIGs 4-9) that includes one or more integrated power transistors, where each power transistor includes an input terminal 155, 175 (e.g., a gate terminal or control terminal), a first current-carrying terminal 156, 176 (e.g., a drain terminal or output terminal), and a second current-carrying terminal (not numbered) (e.g., a source terminal). As indicated above, each input terminal 155, 175 is electrically connected through the input matching network 152, 172 to an input side signal terminal 140, 141. Further, one of the current-carrying terminals 156, 176 (e.g., the drain terminal) is electrically connected through the output matching network 158, 178 to one of the output side signal leads 144, 145. The other current-carrying terminals (e.g., the source terminals) are electrically connected to a ground reference (or another voltage reference).

The output side signal lead 144 along the carrier amplifier path 150 and the output side signal lead 145 along the peaking amplifier path 170 each are physically and electrically connected to a conductive pad (e.g., pads 460, 461, FIGs 4-9) on the transmitter substrate 110, which in turn are coupled through an output combining network 180 to a power combining node 190. Both the output combining network 180 and the power combining node 190 are located on the output portion 108 of the transmitter substrate 110.

According to an embodiment, the output combining network 180 includes one or more phase delay circuits 181, 182 (e.g., transmission lines) formed on or within the transmitter substrate 110, along with connections between opposite ends of the phase delay circuits 181, 182 and the first and second output side signal leads 144, 145. The output combining network 180 is configured to impart an impedance inversion on the amplified carrier signal, and to phase-align the amplified carrier and peaking signals before they are combined together at the power combining node 190.

In the embodiment of FIG. 1, the output combining network 180 is configured to impart phase delays both to the amplified carrier signal and to the amplified peaking signal before they reach the combining node 190. More specifically, according to an embodiment, output combining network 180 includes a carrier-side phase delay circuit 181 and a peaking-side phase delay circuit 182. Each of the carrier-side phase delay circuit 181 and the peaking-side phase delay circuit 182 include one or more transmission lines that extend between the first and second output side signal leads 144, 145, respectively, and the combining node 190.

According to an embodiment, the total electrical length of the signal transmission path between the carrier amplifier output terminal 156 (including the output matching network 158) and the combining node 190 may be about 90 + (180 x n) degrees at the fundamental frequency of operation, *f₀*, of the Doherty power amplifier 109, wherein *n* = 0 or 1. Accordingly, in various embodiments, a 90 degree or 270 degree relative phase shift may be applied to the amplified carrier signal between the carrier amplifier output terminal 156 and the power combining node 190 at the fundamental frequency of operation, *f₀*. Conversely, the total electrical length of the signal transmission path between the peaking amplifier output terminal 176 (including the output matching network 178 and the peaking-side phase delay circuit 182) and the combining node 190 may be about *n* x 180 degrees, wherein n = 1 or 2, at the fundamental frequency of operation, *f₀*. Accordingly, in various embodiments, a 180 degree or 360 degree relative phase shift is applied to the amplified peaking signal between the peaking amplifier output terminal 176 and the power combining node 190 at the fundamental frequency of operation, *f₀*. Again, in amplifier 109, the output combining network 180 is configured so that the amplified carrier and peaking RF signals arrive at and combine in phase at the combining node 190. It should be noted here that the phase delays applied along the carrier and peaking amplifier paths 150, 170 may be different from those described above, as long as the total phase delay along each amplifier path 150, 170 results in the carrier and peaking signals being aligned, in phase, at the combining node 190.

In the transmitter platform 100 of FIG. 1, the combining node 190 is electrically coupled through an output impedance transformer 192 and a circulator 195 to an output terminal 196. The output terminal 196, in turn, is coupled to a load (e.g., an antenna 197). The output impedance transformer 192 functions to present proper load impedances to each of the carrier and peaking amplifier transistors 154, 174. The circulator 195 includes a transmit port coupled through the output impedance transformer to the combining node 190, an antenna port coupled to the output terminal 196 and the antenna 197, and a third port, which in various embodiments may be coupled to a receiver (not illustrated) or to a resistive load (e.g., a 50 ohm load) (not illustrated). The circulator 195 functions to route signals that are received at the transmit port to the antenna port and, ultimately, to the output terminal 196 and antenna 197. In addition, the circulator 195 may function to route signals received from the antenna 197 at the antenna port to the receive port. In other embodiments, a transmitter platform may include one or more RF switches to achieve this functionality.

According to an embodiment, a power coupler 193 is coupled to the transmission path between the combining node 190 and the circulator 195. Based on the forward transmit signal, a reflected signal, or both, the power coupler 193 may produce a feedback signal, which may be conveyed through a feedback trace 194 to a feedback terminal 118. The feedback signal may be provided to the transmit signal processor 101 through terminal 118, and the transmit signal processor 101 may perform digital predistortion (DPD) on the transmit signal based on the feedback signal.

Doherty power amplifier 109 is configured so that the carrier amplifier path 150 provides amplification for relatively low level input signals, and both the carrier and peaking amplifier paths 150, 170 operate in combination to provide amplification for relatively high level input signals. This may be accomplished, for example, by biasing the carrier amplifier transistor 154 so that the carrier amplifier transistor 154 operates in a class AB mode, and biasing the peaking amplifier transistor 174 so that the peaking amplifier transistor 174 operates in a class C mode. Accordingly, the bias voltages provided to the gates and/or drains of the carrier and peaking amplifier transistors 154, 174 may be provided to configure the carrier and peaking amplifier transistors to operate in class AB mode and class C mode, respectively.

To provide the appropriate bias voltages, the Doherty power amplifier 109 also includes gate and drain bias circuitry on the transmitter substrate 110 and within the packaged power amplifier device 130. As indicated previously, the gate and drain bias circuitry may receive bias voltages from external voltage supply circuits 103-106 through bias voltage terminals 114-117 on the transmitter substrate 110.

More specifically, bias voltage terminal 114 is configured to be connected to a first bias voltage power supply 103 that produces a first bias voltage, V_{IN-1}, for a control (input/gate) terminal 155 of the carrier amplifier transistor 154 within the power amplifier device 130. The first bias voltage also may be referred to as a gate-source voltage for the carrier amplifier transistor 154, or Vos-c. According to one or more embodiments, a conductive trace coupled to the input portion 107 of the transmitter substrate 110 conveys the first bias voltage from the bias voltage terminal 114 to the first input side signal lead 140 of the power amplifier device 130. The first bias voltage is then conveyed from the first input side signal lead 140 through the input matching network 152 to the input terminal 155 of the carrier amplifier transistor 154.

Similarly, bias voltage terminal 116 is configured to be connected to a second bias voltage power supply 105 that produces a second bias voltage, V_{IN-2}, for a control (input/gate) terminal 175 of the peaking amplifier transistor 174 within the power amplifier device 130. The second bias voltage may be referred to as a gate-source voltage for the peaking amplifier transistor 174, or V_{GS-P}. According to one or more embodiments, a conductive trace coupled to the input portion 107 of the transmitter substrate 110 conveys the second bias voltage from the bias voltage terminal 116 to the second input side signal lead 141 of the power amplifier device 130. The second bias voltage is then conveyed from the second input side signal lead 141 through the input matching network 172 to the input terminal 175 of the peaking amplifier transistor 174.

Besides providing the gate-source bias voltages, proper operation of the Doherty power amplifier 109 also requires drain-source bias voltages to be provided to the output terminals 156, 176 of the carrier and peaking power transistors 154, 174. According to one or more embodiments, the drain-source bias voltages are provided to the output terminals 156, 176 through the above-mentioned first and second RF cold points and/or through the first and second output side signal leads 144, 145, which are coupled to the output portion 108 of the transmitter substrate 110.

Embodiments of the inventive subject matter include unique bias voltage routing paths to convey the drain-source bias voltages from the bias terminals 115, 117 on the input portion 107 of the transmitter substrate 110 to the first and second RF cold points and/or to the first and second output side signal leads 144, 145. As will be discussed in detail later, rather than using conventional methods to route the drain-source bias voltages from the input portion 107 around the power amplifier device 130 to the output portion 108 using traces on the transmitter substrate 110, embodiments of the inventive subject matter include a power amplifier device 130 that includes one or more input-to-output bias-conducting structures 133, 135. Each of the input-to-output bias-conducting structures 133, 135 is configured to route a drain-source bias voltage directly through the device 130 from the input side to the output side of the device 130. As an example, a first input-to-output bias-conducting structure 133 within device 130 includes a first input side bias lead 142, a first output side bias lead 146, and a first interior conductive structure 134 coupled between the first bias leads 142, 146. Similarly, a second input-to-output bias-conducting structure 135 within device 130 includes a second input side bias lead 143, a second output side bias lead 147, and a second interior conductive structure 136 coupled between the second bias leads 143, 147.

According to one or more embodiments, the device 130 also may include first and second conductive structures 137, 138 (e.g., each including one or more wirebonds) coupled between the first and second interior conductive structures 134, 136 (or the first and second output side bias leads 146, 147) and first and second RF cold points along the carrier and peaking amplifier paths 150, 170, respectively. For example, a first RF cold point may be present at a circuit node within the carrier output matching network 158, and a second RF cold point may be present at a circuit node within the peaking output matching network 178.

More specifically, to provide a bias voltage to the output terminal 156 of the carrier amplifier transistor 154, bias voltage terminal 115 is connected to a third bias voltage power supply 104 that produces a third bias voltage, V_{OUT-1} . The third bias voltage also may be referred to as a drain-source voltage for the carrier amplifier transistor 154, or V_{DS-C}.

According to one or more embodiments, a conductive trace coupled to the input portion 107 of the transmitter substrate 110 conveys the third bias voltage from the bias voltage terminal 115 to the first input side bias lead 142 of the power amplifier device 130. The third bias voltage is then conveyed from the first input side bias lead 142 through the device 130 (i.e., through the interior conductive structure 134) to the first output side bias lead 146.

The third bias voltage may then be conveyed to the output terminal 156 of the carrier amplifier transistor 154 in multiple ways, according to various embodiments. For example, in one or more embodiments, all or a portion of the third bias voltage may be conveyed from the interior conductive structure 134 (or the first output side bias lead 146) through the first conductive structure 137 and the first RF cold point to the output terminal 156 of the carrier amplifier transistor 154. In one or more other embodiments, all or a portion of the third bias voltage also or alternatively may be conveyed from the first output side bias lead 146 through a conductive path 183 (or "drain feeder trace") on the output portion 108 of the transmitter substrate 110 to the first output side signal lead 144 of the power amplifier device 130. In such embodiments, the third bias voltage is then conveyed from the first output side signal lead 144 through the output matching network 158 to the output terminal 156 of the carrier amplifier transistor 154.

In some embodiments, the first conductive structure 137 is capable of handling an entirety of the DC current associated with the third bias voltage, which may be up to 10 amps, for example. In such embodiments, the conductive path 183 on the output portion 108 of the transmitter substrate 110 may be excluded or optional. In other embodiments, the first conductive structure 137 may be excluded, and all of the DC current associated with the third bias voltage may be conveyed through the conductive path 183. In other words, some embodiments may include only the first conductive structure 137 (but not the conductive path 183), while other embodiments may include only the conductive path 183 (but not the first conductive structure 137), while still other embodiments may include both the first conductive structure 137 and the conductive path 183. However it is implemented, the conductive structures that route the third bias voltage from the bias voltage terminal 115 to the output terminal 156 of the carrier amplifier transistor 154 are collectively referred to herein as a first "output DC bias voltage conduction path."

Similarly, to provide a bias voltage to the output terminal 176 of the peaking amplifier transistor 174, bias voltage terminal 117 is connected to a fourth bias voltage power supply 106 that produces a fourth bias voltage, V_{OUT-2}. The fourth bias voltage also may be referred to as a drain-source voltage for the peaking amplifier transistor 174, or V_{DS-P}. According to one or more embodiments, a conductive trace coupled to the input portion 107 of the transmitter substrate 110 conveys the fourth bias voltage from the bias voltage terminal 117 to the second input side bias lead 143 of the power amplifier device 130. The fourth bias voltage is then conveyed from the second input side bias lead 143 through the device 130 (i.e., through the interior conductive structure 136) to the second output side bias lead 147.

The fourth bias voltage may then be conveyed to the output terminal 176 of the peaking amplifier transistor 174 in multiple ways, according to various embodiments. For example, in one or more embodiments, all or a portion of the fourth bias voltage may be conveyed from the interior conductive structure 136 (or the second output side bias lead 147) through the second conductive connection 138 and the second RF cold point to the output terminal 176 of the peaking amplifier transistor 174. In one or more other embodiments, all or a portion of the fourth bias voltage also or alternatively may be conveyed from the second output side bias lead 147 through a conductive path 186 (or "drain feeder trace") on the output portion 108 of the transmitter substrate 110 to the second output side signal lead 145 of the power amplifier device 130. In such embodiments, the fourth bias voltage is then conveyed from the second output side signal lead 145 through the output matching network 178 to the output terminal 176 of the peaking amplifier transistor 174.

Again, in some embodiments, the second conductive structure 138 is capable of handling an entirety of the DC current associated with the fourth bias voltage, which may be up to 10 amps, for example. In such embodiments, the conductive path 186 on the output portion 108 of the transmitter substrate 110 may be excluded or optional. In other embodiments, the second conductive structure 138 may be excluded, and all of the DC current associated with the fourth bias voltage may be conveyed through the conductive path 186. In other words, some embodiments may include only the second conductive structure 138 (but not the conductive path 186), while other embodiments may include only the conductive path 186 (but not the second conductive structure 138), while still other embodiments may include both the second conductive structure 138 and the conductive path 186. However it is implemented, the conductive structures that route the fourth bias voltage from the bias voltage terminal 117 to the output terminal 176 of the peaking amplifier transistor 174 are collectively referred to herein as a second "output DC bias voltage conduction path."

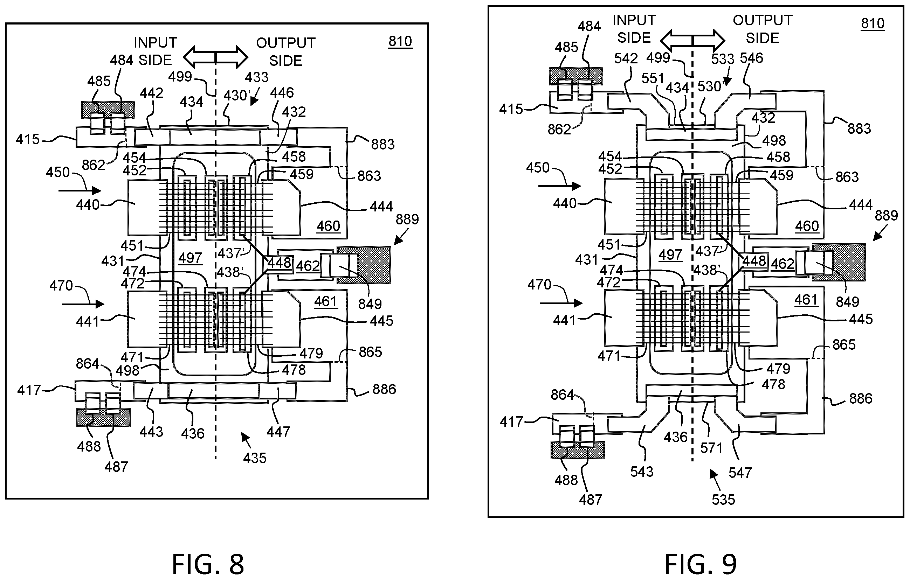

According to one or more embodiments, the Doherty power amplifier 109 may include additional circuitry along the first and second output DC bias voltage conduction paths that provide for decoupling in the DC and RF frequency domains. Essentially, the decoupling circuitry is configured to isolate the third and fourth DC bias voltages from the RF signals conveyed along the carrier and peaking amplifier paths 150, 170 to ensure that RF signal energy is not conveyed to the third and fourth bias voltage power supplies 104, 106. For example, in some embodiments and as shown in FIG. 1 (and in FIGs 2-7), DC decoupling capacitors 184, 187 and RF decoupling capacitors 185, 188 may be coupled between the output side bias leads 146, 147 and a ground reference node. In alternate embodiments, as will be discussed in more detail in conjunction with FIGs 8 and 9, the DC decoupling capacitors 184, 187 and/or the RF decoupling capacitors 185, 188 instead may be coupled between the input side bias leads 142, 143 and a ground reference node. Either way, the DC decoupling capacitors 184, 187 are configured, during operation, to convey to ground, any voltage spikes or other transients that may flow through the first and second output DC bias voltage conduction paths.

In addition, the RF decoupling capacitors 185, 188 may be electrically connected through the conductive paths 183, 186 to conductive pads (e.g., pads 460, 461, FIGs 4, 5) to which the output side signal leads 144, 145 are coupled. When the conductive paths 183, 186 are configured as quarter wavelength lines (between the RF decoupling capacitors 185, 188 and the conductive pads), an open circuit condition for RF signal energy is present where the conductive paths 183, 186 connect to the conductive terminal pads. Accordingly, the RF decoupling capacitors 185, 188 and the conductive paths 183, 186 are configured, during operation, to decouple the third and fourth bias voltages (produced by power supplies 104, 106) from the RF signals flowing through the carrier and peaking amplifier paths 150, 170.

Further still, according to one or more embodiments, the Doherty power amplifier 109 also may include a video bandwidth (VBW) circuit 189, which may be coupled to the first and second RF cold points along the carrier and peaking amplifier paths 150, 170. The VBW circuit 189 may function to improve the low frequency resonance (LFR) of Doherty power amplifier 109. The VBW circuit 189 essentially may be considered to be "invisible" from an RF matching standpoint, as it primarily affects the impedance at envelope frequencies (i.e., the VBW circuit 189 provides terminations for the envelope frequencies of amplifier 109). According to one or more embodiments, the VBW circuit 189 may include conductive structures 137', 138' (e.g., wirebonds) between the first and second RF cold points and an "extra" output side lead 148 of device 130, and a capacitor 149 with a first terminal coupled to the extra output side lead 148 and a second terminal coupled to a ground reference node. For example, the extra output side lead 148 may be positioned between the first and second output side signal leads 144, 145. In other embodiments, the VBW circuit 189 may be omitted.

Examples of physical implementations of transmitter platforms 200, 300 (e.g., embodiments of transmitter platform 100, FIG. 1) will now be discussed in conjunction with FIGs 2 and 3, respectively. Specifically, FIG. 2 is a top view of a transmitter platform 200 that includes a first embodiment of a packaged power amplifier device 230 (e.g., a first embodiment of device 130, FIG. 1), and FIG. 3 is a top view of a transmitter platform 300 that includes a second and different embodiment of a packaged power amplifier device 330 (e.g., a second embodiment of device 130, FIG. 1), in accordance with various example embodiments. As will be discussed in more detail later, the primary difference between the transmitter platforms 200, 300 is that power amplifier device 230 includes straight bias leads 242, 243, 246, 247 (e.g., leads 142, 143, 146, 147, FIG. 1), and power amplifier device 330 includes "insect-type" bias leads 342, 343, 346, 347 (e.g., leads 142, 143, 146, 147, FIG. 1).

Many of the features and elements of FIGs 2 and 3 correspond with features and elements of FIG. 1. For the purpose of enhanced understanding, the reference numbers of features of FIGs 2 or 3 that correspond with features of FIG. 1 will have the same last two digits (e.g., power amplifier devices 230, 330 correspond to different embodiments of power amplifier device 130). For the purpose of brevity, all of the details of various features in FIG. 1 may not be repeated here in the description of corresponding features in FIGs 2 and 3. However, the details regarding such corresponding features are intended to be incorporated into this description of FIGs 2 and 3.

Referring to both FIGs 2 and 3 simultaneously, each of transmitter platforms 200, 300 (i.e., different embodiments of transformer platform 100, FIG. 1) essentially includes a Doherty power amplifier (e.g., amplifier 109, FIG. 1) implemented on a transmitter substrate 210, 310 (e.g., transmitter substrate 110, FIG. 1). Again, the Doherty power amplifier includes circuitry that is directly coupled to the transmitter substrate 210, 310 and circuitry disposed within a packaged power amplifier device 230, 330 (e.g., different embodiments of device 130, FIG. 1) that is mounted to the transmitter substrate 210, 310.

Each transmitter substrate 210, 310 may include, for example, a PCB or other suitable substrate. Each transmitter substrate 210, 310 has an input side 211, an output side 212 opposite the input side, and a transmitter substrate mounting surface that extends between the input side and the output side 211, 212. Further, each transmitter substrate 210, 310 has an input portion (e.g., portion 107, FIG. 1) that extends from the input side 211 to a bisection line 299 between the input side 211 and the output side 212. The transmitter substrate 210, 310 also includes an output portion (e.g., portion 108, FIG. 1) that extends from the output side 212 to the bisection line 299. The dimensions of the transmitter substrate 210, 310 include a length dimension (not numbered) that defines the distance between the input and output sides 211, 212, and a width dimension 202 (FIG. 2) or 302 (FIG. 3), which is perpendicular to the length dimension.

Each packaged power amplifier device 230, 330 (e.g., device 130, FIG. 1) is a discrete, surface-mountable device that is configured to be coupled to the mounting surface of the transmitter substrate 210, 310. Each packaged power amplifier device 230, 330 has a package body with an input side 231, 331 and output side 232, 332, and transverse sides (not numbered in FIG. 2, and numbered 351, 371 in FIG. 3) that extend between the input and output sides 231, 232, 331, 332. Further, each packaged power amplifier device 230, 330 also has an input side 231, 331 and an opposite output side 232, 332. Along with defining the input and output portions of the transmitter substrate 210, 310, the bisection line 299 also defines input and output portions of each power amplifier device 230, 330.

According to one or more embodiments, distal ends of conductive signal leads 240, 241, 244, 245 (e.g., leads 140, 141, 144, 145, FIG. 1) of the packaged power amplifier device 230, 330 are physically and electrically coupled to conductive bond pads (not numbered) at the mounting surface of the transmitter substrate 210, 310. Similarly, distal ends of the conductive bias leads 242, 243, 246, 247, 342, 343, 346, 347 (e.g., leads 142, 143, 146, 147, FIG. 1) of the device 230, 330 are physically and electrically coupled to other conductive bond pads (not numbered) at the mounting surface of the transmitter substrate 210, 310.

A plurality of input/output and bias terminals 213-218 (e.g., terminals 113-118, FIG. 1) are coupled to the input portion of the transmitter substrate 210, 310 (e.g., terminals 213-218 are positioned at or proximate to the input side 211 of the transmitter substrate 210, 310). In some embodiments, the terminals 213-218 may be configured to be connected directly to a system substrate associated with a transmitter system. In other embodiments, the terminals 213-218 may form portions of an edge connector 219 at the input side 211 of the transmitter substrate 210, 310. As discussed previously, all of the input/output signals and bias voltages are provided to the transmitter platform 200, 300 from the input portion of the transmitter substrate 210, 310, and in some embodiments, from the edge connector 219 at the input side 211 of the transmitter substrate 210, 310.

According to one or more embodiments, the terminals 213-218 include a signal input terminal 213 (e.g., terminal 113, FIG. 1), various bias voltage terminals 214-217 (e.g., terminals 114-117, FIG. 1), and a feedback terminal 218 (e.g., terminal 118, FIG. 1). The feedback terminal 218 is configured to convey a feedback signal from a power coupler 293 (e.g., coupler 193, FIG. 1) that is coupled to the transmitter substrate 210, 310.

The transmitter substrate 210, 310 houses the Doherty power amplifier. According to one or more embodiments, the Doherty power amplifier includes the signal input terminal 213, a power splitter 220 (e.g., power splitter 120, FIG. 1), a carrier amplifier path (e.g., path 150, FIG. 1) that extends through the packaged power amplifier device 230, 330, a peaking amplifier path (e.g., path 170, FIG. 1) that extends through the packaged power amplifier device 230, 330, and an output combining network (e.g., network 180, FIG. 1), including a combining node 290 (e.g., combining node 190, FIG. 1).

As discussed above, an input RF signal received at the signal input terminal 213 is received by and divided by the power splitter 220 into first and second RF signals (or carrier and peaking signals). The carrier signal is amplified along the carrier amplifier path, the peaking signal is amplified along the peaking amplifier path, and the amplified carrier and peaking signals combine at the combining node 290. An amplified signal produced at the combining node 290 is then conveyed through an output impedance transformer 292 (e.g., transformer 192, FIG. 1) and optionally through a circulator 295 (e.g., circulator 195, FIG. 1) to a load (e.g., an antenna 197).

The Doherty power amplifier also includes a plurality of bias voltage routing paths that are configured to route various bias voltages to the inputs (gates) and outputs (drains) of the power transistors within device 230, 330. As discussed previously, the various bias voltages are necessary to ensure proper biasing and operation of the Doherty power amplifier.

For example, the Doherty power amplifier includes input bias voltage routing paths that include input (gate) bias terminals 214, 216 (e.g., terminals 114, 116, FIG. 1) and conductive paths (not numbered) on the transmitter substrate 210, 310. The input bias voltage routing paths are configured to convey input bias voltages received at the input bias terminals 214, 216 to the input terminals of the power transistors of the carrier and peaking amplifier paths.

Further, the Doherty power amplifier includes output bias voltage routing paths that include output (drain) bias terminals 215, 217 (e.g., terminals 115, 117, FIG. 1), conductive bias paths 315, 317 on the input portion of the transmitter substrate 210, 310, first and second input-to-output bias-conducting structures (e.g., structures 133, 135, FIG. 1) that extend through the device 230, 330, and, in some embodiments, additional conductive paths 283, 286 on the output portion of the transmitter substrate 210, 310. It may be noted here that the conductive bias paths 315, 317 are contained within the input portion (e.g., portion 107, FIG. 1) of the transmitter substrate 210, 310, and do not extend past the bisection line 299. The output bias voltage routing paths are configured to convey output bias voltages received at the output bias terminals 215, 217 to the output terminals of the power transistors of the carrier and peaking amplifier paths.

As discussed in conjunction with FIG. 1, each of the first and second input-to-output bias-conducting structures (e.g., structures 133, 135, FIG. 1) includes input side bias leads 242, 243, 342, 343 (e.g., leads 142, 143, FIG. 1) and output side bias leads 246, 247, 346, 347 (e.g., leads 146, 147, FIG. 1) and an interior conductive structure (e.g., structures 134, 136, FIG. 1) coupled between the input side bias leads 242, 243, 342, 343 and the output side bias leads 246, 247, 346, 347. In FIGs 2 and 3, only the input side bias leads 242, 243, 342, 343 and the output side bias leads 246, 247, 346, 347 are visible, as the interior conductive structures are embedded within the devices 230, 330.

Each of the first and second input-to-output bias-conducting structures functions to convey an output bias voltage from the input portion of the transmitter substrate 210, 310 to the output portion of the transmitter substrate 310 through the device 230, 330. This is in contrast with other designs, in which output bias voltages may be conveyed from the input to output portions of a transmitter substrate using conductive traces on the transmitter substrate that lie on either side of the packaged power amplifier device. Because the output bias voltages may be conveyed through the devices 230, 330 according to various embodiments, the widths 202, 302 of the transmitter substrates 210, 310 may be designed to be narrower than widths that are achievable using designs that route the output bias voltages around the devices on the transmitter substrate.

In the embodiment illustrated in FIG. 2, device 230 (FIG. 2) includes "straight" bias leads 242, 243, 246, 247 (e.g., leads 142, 143, 146, 147, FIG. 1) that extend directly and perpendicularly from the input side 231 or from the output side 232 of device 230. Distal (exterior) ends of the straight input side bias leads 242, 243 are physically and electrically coupled to the conductive paths 315, 317 on the input portion of the transmitter substrate 210. Distal (exterior) ends of the straight output side bias leads 246, 247 are physically and electrically coupled to the additional conductive paths 283, 286 on the output portion of the transmitter substrate 210. Proximal (interior) ends of the straight bias leads 242, 243, 246, 247 are physically and electrically coupled to opposite ends of the interior conductive structures (e.g., structures 134, 136, FIG. 1).

In contrast, in the embodiment of FIG. 3, device 330 includes "insect-type" bias leads 342, 343, 346, 347 (e.g., leads 142, 143, 146, 147, FIG. 1) that extend from "transverse" sides 351, 371 of the device 330. The transverse sides 351, 371 of device 330 are perpendicular to and extend between the input and output sides 331, 332 of device 330. According to one or more embodiments, the insect-type bias leads 342, 343, 346, 347 extend directly and perpendicularly from the transverse sides 351, 371 of the device 330. In addition, each of the insect-type input side bias leads 342, 343 may include a 90 degree bend and a portion that extends toward and beyond the input side 331 of the device 330. Similarly, each of the insect-type output side bias leads 346, 347 also may include a 90 degree bend and a portion that extends toward and beyond the output side 332 of the device 330.

Distal (exterior) ends of the insect-type input side bias leads 342, 343 are physically and electrically coupled to the conductive paths 315, 317 on the input portion of the transmitter substrate 310. Distal (exterior) ends of the insect-type output side bias leads 346, 347 are physically and electrically coupled to the additional conductive paths 283, 286 on the output portion of the transmitter substrate 310. Proximal (interior) ends of the insect-type bias leads 342, 343, 346, 347 are physically and electrically coupled to opposite ends of the interior conductive structures (e.g., structures 134, 136, FIG. 1).

The straight or insect-type bias leads each have their respective advantages and disadvantages, which may warrant selecting one or the other type of lead for a given design. For example, including straight bias leads 242, 243, 246, 247 (FIG. 2) in a device 230 may enable the width 202 (FIG. 2) of the transmitter substrate 210 to be smaller than a width 302 (FIG. 3) of the transmitter substrate 310, which may be realized when insect-type bias leads 342, 343, 346, 347 (FIG. 3) are included in a device 330.

Detailed descriptions of several embodiments of power amplifier devices 430, 530, 430', 530' (e.g., devices that may be substituted for devices 130, 230, 330, FIGs 1-3) and various bias circuits will now be discussed in conjunction with FIGs 4-9. For example, FIGs 4 and 5 are top views of two embodiments of power amplifier devices 430, 530 that include straight bias leads (device 430, FIG. 4) or insect-type bias leads (device 530, FIG. 5), respectively. These devices 430, 530 may be included within any of the transmitter platforms 100, 200, 300 of FIGs 1-3, and embodiments of portions of those transmitter platforms also are depicted in FIGs 4 and 5. It should be noted here that the internal components of power amplifier devices 430, 530 are illustrated for enhanced understanding, and that the interior components of the actual devices would be obscured by encapsulation (for an overmolded device) or a cap (for an air-cavity device).

Each device 430, 530 is physically and electrically coupled to a transmitter substrate 410 (e.g., substrate 110, 210, 310, FIGs 1-3), where only a portion of the transmitter substrate 410 is shown in FIGs 4 and 5. Remaining portions of the transmitter substrate 410 may be similar or identical to portions of transmitter substrates 110, 210, 310 discussed in conjunction with FIGs 1-3. To enable enlargement of various features of the devices 430, 530 in FIGs 4 and 5, those remaining portions are not illustrated in FIGs 4 and 5.

Each device 430, 530 has a package body with an input side 431, 531 (e.g., side 131, FIG. 1) and output side 432, 532 (e.g., side 132, FIG. 1), and transverse sides (not numbered in FIG. 4, and numbered 551, 571 in FIG. 5) that extend between the input and output sides 431, 432, 531, 532. In each of devices 430, 530, a bisection line 499 defines an input portion (from bisection line 499 to input side 431) and an output portion (from bisection line 499 to output side 432) of the device 430, 530. As also discussed previously, each device 430, 530 may include first and second input side signal leads 440, 441 (e.g., leads 140, 141, 240, 241, FIGs 1-3), first and second output side signal leads 444, 445 (e.g., leads 144, 145, 244, 245, FIGs 1-3), first and second input side bias leads 442, 443, 542, 543 (e.g., leads 142, 143, 242, 243, 342, 343, FIGs 1-3), and first and second output side bias leads 446, 447, 546, 547 (e.g., leads 146, 147, 246, 247, 346, 347, FIGs 1-3).

The first and second input side signal leads 440, 441 are physically and electrically coupled to conductive pads (not illustrated) on the input portion of the transmitter substrate 410, which in turn are electrically coupled to outputs (e.g., outputs 124, 126, FIG. 1) of the power splitter (e.g., power splitter 120, 220, FIGs 1-3) of the Doherty power amplifier. Similarly, the first and second output side signal leads 444, 445 are physically and electrically coupled to conductive pads 460, 461, respectively, on the output portion of the transmitter substrate 410, which in turn are electrically coupled to the combining node (e.g., combining node 190, 290, FIGs 1-3) of the Doherty power amplifier.

The first and second input side bias leads 442, 443, 542, 543 are physically and electrically coupled to conductive paths 415, 417 (e.g., paths 315, 317, FIGs 2, 3) on the input portion of the transmitter substrate 410, which in turn are electrically coupled to output (drain) bias terminals (e.g., terminals 115, 117, 215, 217, FIGs 1-3). Finally, the first and second output side bias leads 446, 447, 546, 547 are physically and electrically coupled to conductive bias paths 483, 486 (e.g., paths 183, 186, 283, 286, FIGs 1-3) on the output portion of the transmitter substrate 410, which in turn are coupled to the first and second output side signal leads 444, 445 through the conductive pads 460, 461.

Additionally, devices 430, 530 each include a flange 497 (or "device substrate"), in an embodiment, which includes a rigid electrically-conductive substrate with a thickness that is sufficient to provide structural support for various electrical components and elements of the device 430, 530. An upper surface of the flange 497 corresponds to a mounting surface that extends between sides 431 and 432 of the device 430, 530. In addition, flange 497 may function as a heat sink for transistor dies 454, 474 and other devices mounted on flange 497. Flange 497 has top and bottom surfaces and a substantially-rectangular perimeter that may correspond, roughly, to the perimeter of the device 430, 530. Only a central portion of the top surface of flange 497 is visible in FIGs 4 and 5.

Flange 497 is formed from an electrically conductive material, and may be used to provide a ground reference node for the device 430, 530. For example, various components and elements may have terminals that are electrically coupled to flange 497, and flange 497 may be electrically coupled to a system ground when the device 430, 530 is incorporated into a larger electrical system (e.g., coupled to a transmitter substrate 110, 210, 310, 410). At least the top surface of flange 497 is formed from a layer of conductive material, and possibly all of flange 497 is formed from bulk conductive material.

In some embodiments, the device 430, 530 corresponds to an "overmolded" type of packaged electronic device, in which the electrical components of the device, interior ends of the device leads 440-447, 542, 543, 546, 547, and the top surface of the flange 497 are covered with a non-conductive encapsulant material (not illustrated). In such embodiments, the device leads 440-447, 542, 543, 546, 547 may form portions of a leadframe (not illustrated), and during fabrication of the package, the leadframe (including the device leads 440-447, 542, 543, 546, 547) may be suspended over the flange 497 during application of the encapsulant material, so that portions of the encapsulant material flow between and electrically isolate the leads 440-447, 542, 543, 546, 547 from the flange 497 after the encapsulation process is completed.

In other embodiments, the device 430, 530 corresponds to an "air-cavity" type of packaged electronic device, in which the electrical components of the device are positioned within a sealed "air cavity" within the interior of the device 430, 530. In such embodiments, an isolation structure 498 is attached to the top surface of flange 497 to define the "walls" and the "floor" of the air cavity, respectively. The "ceiling" of the air cavity may be defined by a cap (not illustrated) coupled to the top of the isolation structure 498. The isolation structure 498, which is formed from a rigid, electrically insulating material, provides electrical isolation between the leads 440-447, 542, 543, 546, 547 and the flange 497. For example, the isolation structure 498 may have a frame shape, which includes a substantially enclosed, four-sided structure with a central opening. The isolation structure 498 may have a substantially rectangular shape, as shown in FIGs 4 and 5, or the isolation structure 498 may have another shape (e.g., annular ring, oval, and so on).

Depending on the package type, the input, output, and bias leads 440-447, 542, 543, 546, 547 are suspended above the flange 497 and/or mounted on a top surface of the isolation structure 498 on opposite sides of the active area of the device 430, 530. Thus, the input, output, and bias leads 440-447, 542, 543, 546, 547 are electrically isolated from the flange 497. Generally, the input, output, and bias leads 440-447, 542, 543, 546, 547 are oriented to allow for attachment of wirebonds between interior ends of the input, output, and bias leads 440-447, 542, 543, 546, 547 and components and elements within the active area of the device 430, 530.

Transistor dies 454, 474 are positioned within an active device area of the device 430, 530, along with passive devices or integrated passive device (IPD) assemblies 452, 458, 472, 478, which will be described in more detail later. The "active area" of the device 430, 530 refers to a portion of the top surface of flange 497 to which the transistor dies 454, 474 and IPD assemblies 452, 458, 472, 478 are coupled. For example, the transistor dies 454, 474 and IPD assemblies 452, 458, 472, 478 may be coupled to the top surface of flange 497 using conductive epoxy, solder, solder bumps, sintering, and/or eutectic bonds.

Each device 430, 530 houses two amplifier paths (indicated with arrows 450, 470), and each amplifier path 450, 470 represents a physical implementation of a portion of a carrier or peaking amplifier path 150, 170 (FIG. 1). When incorporated into a Doherty amplifier (e.g., Doherty amplifier 109, FIG. 1), amplifier path 450 may correspond to a portion of a carrier amplifier path (e.g., carrier amplifier path 150, FIG. 1), and amplifier path 470 may correspond to a portion of a peaking amplifier path (e.g., peaking amplifier path 170, FIG. 1).

The amplifier paths 450, 470 may be arranged in parallel with each other in a central area of the device 430, 530. Each amplifier path 450, 470 includes an input lead 440, 441 (e.g., input leads 140, 141, 240, 241, FIGs 1-3), an output lead 444, 445 (e.g., output lead 144, 145, 244, 245, FIGs 1-3), one or more transistor dies 454, 474 (e.g., including transistors 154, 174, FIG. 1), an input impedance matching network (e.g., input impedance matching network 152, 172, FIG. 1), and an output impedance matching network (e.g., output impedance matching network 158, 178, FIG. 1). Each input impedance matching network includes wirebonds 451, 471 and IPD structures 452, 472, and each output impedance matching network includes IPD structures 458, 478 and wirebonds 459, 479.

According to one or more embodiments, each of the transistor dies 454, 474 includes a semiconductor substrate on which a power transistor (e.g., transistor 154, 174, FIG. 1) is formed. An input (gate terminal) of the power transistor is electrically coupled to an input terminal (not numbered) at the top surface of the die 454, 474, and an output (drain terminal) of the power transistor is electrically coupled to an output terminal (not numbered) at the top surface of the die 454, 474. A third terminal (source terminal) of the power transistor is electrically coupled to the flange 497 (i.e., to a ground reference node). According to one or more embodiments, each power transistor may include a III-V field effect transistor (FET) (e.g., a gallium nitride (GaN) FET or another type of III-V transistor). Alternatively, each power transistor may include a silicon-based transistor or another type of transistor.

According to one or more embodiments, each of the IPD structures 452, 458, 472, 478 includes a shunt capacitor (and possibly other passive components). A first terminal of each shunt capacitor is electrically coupled to a conductive bondpad (not numbered) at the top surface of the IPD structure 452, 458, 472, 478, and a second terminal of each capacitor is electrically coupled to the conductive flange 497 (i.e., to a ground reference node).

According to one or more embodiments, the input matching network (e.g., input impedance matching network 152, 172, FIG. 1) of each amplifier path 450, 470 more specifically may include a T-match circuit with first and second sets of wirebonds 451, 471 (series inductances) that extend from the input side signal lead 440, 441 to the conductive bondpad (first capacitor terminal) at the top surface of each IPD structure 452, 472, and from the conductive bondpad (first capacitor terminal) of each IPD structure 452, 472 to the conductive bondpad corresponding to the input terminal of the power transistor die 454, 474. In addition, the input matching network includes the above-mentioned shunt capacitor within each IPD structure 452, 472.

According to one or more further embodiments, the output matching network (e.g., output impedance matching network 158, 178, FIG. 1) of each amplifier path 450, 470 more specifically includes a matching network with first and second sets of wirebonds 459, 479 (shunt and series inductances). A first set of the wirebonds (series inductance) extends from the conductive bondpad corresponding to the output terminal of the power transistor die 454, 474 to the output side signal lead 444, 445. A second set of the wirebonds (shunt inductance) extends from the conductive bondpad corresponding to the output terminal of the power transistor die 454, 474 to the conductive bondpad (first capacitor terminal) at the top surface of IPD structure 458, 478. In addition, the output matching network includes the above-mentioned shunt capacitor within each IPD structure 458, 478. According to one or more embodiments, the conductive bondpad at the top surface of each IPD structure 458, 478 corresponds to an RF cold point along the carrier and peaking amplifier paths 450, 470.

In addition to the above-described features and circuitry, the device includes first and second (or carrier and peaking) input-to-output bias-conducting structures 433, 435 or 533, 535 (e.g., structures 133, 135, FIG. 1). According to one or more embodiments, the input-to-output bias-conducting structures 433, 435 or 533, 535 are positioned outside of the central area of the device (i.e., on either side of the carrier or peaking amplifier paths 450, 470). In other words, neither of the input-to-output bias-conducting structures 433, 435 or 533, 535 are positioned between the carrier and peaking amplifier paths 450, 470. In other embodiments, either or both of the input-to-output bias-conducting structures 433, 435 or 533, 535 may be positioned between the carrier and peaking amplifier paths 450, 470.

As discussed previously, each of the input-to-output bias-conducting structures 433, 435 or 533, 535 is configured to route a drain-source bias voltage directly through the device 430, 530 from the input side 431 to the output side 432 of the device 430, 530. In the example device 430 of FIG. 4, the device 430 includes a first input-to-output bias-conducting structure 433 and a second input-to-output bias-conducting structure 435. The first input-to-output bias-conducting structure includes a first "straight" input side bias lead 442 (e.g., lead 142, 242, FIGs 1, 2) that extends perpendicularly from the input side 431 next to (but spaced apart from) the first input signal lead 440, a first "straight" output side bias lead 446 (e.g., lead 146, 246, FIGs 1, 2) that extends perpendicularly from the output side 432 next to (but spaced apart from) the first output signal lead 444, and a first interior conductive structure 434 (e.g., structure 134, FIG. 1) physically and electrically coupled between the first bias leads 442, 446. More particularly, a first end of the first interior conductive structure 434 is connected to the first input side bias lead 442, and a second end of the first interior conductive structure 434 is connected to the first output side bias lead 446. The interior conductive structure 434 is fully contained within the package body, according to one or more embodiments (i.e., the interior conductive structure 434 is positioned between the mounting surface of the flange 497 and the transverse side of the package body).

Similarly, the second input-to-output bias-conducting structure 435 includes a "straight" second input side bias lead 443 (e.g., lead 143, 243, FIGs 1, 2) that extends perpendicularly from the input side 431 next to (but spaced apart from) the second input signal lead 441, a second "straight" output side bias lead 447 (e.g., lead 147, 247, FIGs 1, 2) that extends perpendicularly from the output side 432 next to (but spaced apart from) the second output signal lead 445, and a second interior conductive structure 436 (e.g., structure 136, FIG. 1) coupled between the second bias leads 443, 447. More particularly, a first end of the second interior conductive structure 436 is connected to the second input side bias lead 443, and a second end of the second interior conductive structure 436 is connected to the second output side bias lead 447. The interior conductive structure 436 also is fully contained within the package body, according to one or more embodiments (i.e., the interior conductive structure 436 is positioned between the mounting surface of the flange 497 and the other transverse side of the package body).

In the example device 530 of FIG. 5, device 530 also includes a first input-to-output bias-conducting structure 533 and a second input-to-output bias-conducting structure 535. However, the physical configuration of the input-to-output bias-conducting structures 533, 535 is different from the structures 433, 435 of device 430 (FIG. 4). The first input-to-output bias-conducting structure in the device 530 of FIG. 5 includes a first "insect-type" input side bias lead 542 (e.g., lead 142, 342, FIGs 1, 3) that extends perpendicularly from the transverse side 551 of the device 530 (with a 90 degree bend and a portion that extends beyond the input side 431), a first "insect-type" output side bias lead 546 (e.g., lead 146, 346, FIGs 1, 3) that extends perpendicularly from the transverse side 551 of the device 530 (with a 90 degree bend and a portion that extends beyond the output side 432), and a first interior conductive structure 434 (e.g., structure 134, FIG. 1) physically and electrically coupled between the first bias leads 542, 546. More particularly, a first end of the first interior conductive structure 434 is connected to the first input side bias lead 542, and a second end of the first interior conductive structure 434 is connected to the first output side bias lead 546. The interior conductive structure 434 is fully contained within the package body, according to one or more embodiments (i.e., the interior conductive structure 434 is positioned between the mounting surface of the flange 497 and the transverse side 551 of the package body).

Similarly, the second input-to-output bias-conducting structure 535 includes a "insect-type" second input side bias lead 543 (e.g., lead 143, 343, FIGs 1, 3) that extends perpendicularly from the transverse side 571 of the device 530 (with a 90 degree bend and a portion that extends beyond the input side 431), a second "insect-type" output side bias lead 547 (e.g., lead 147, 347, FIGs 1, 3) that extends perpendicularly from the transverse side 571 of the device 530 (with a 90 degree bend and a portion that extends beyond the output side 432), and a second interior conductive structure 436 (e.g., structure 136, FIG. 1) coupled between the second bias leads 543, 547. More particularly, a first end of the second interior conductive structure 436 is connected to the second input side bias lead 543, and a second end of the second interior conductive structure 436 is connected to the second output side bias lead 547. The interior conductive structure 436 is fully contained within the package body, according to one or more embodiments (i.e., the interior conductive structure 436 is positioned between the mounting surface of the flange 497 and the transverse side 571 of the package body).

It may be noted here that the first and second input-to-output bias-conducting structures 433, 435, 533, 535 are not physically directly connected to the input or output signal leads 440, 441, 444, 445. However, in order to provide the output bias voltages conveyed through these structures 433, 435, 533, 535 to the power transistors within dies 454, 474, the first and second input-to-output bias-conducting structures 433, 435, 533, 535 are electrically coupled to the output terminals of the power transistor dies 454, 474 through one or more output DC bias voltage conduction paths.

For example, in some embodiments, the first and second input-to-output bias-conducting structures 433, 435, 533, 535 may be electrically connected through one or more conductive structures 437, 438 (e.g., structures 137, 138, FIG. 1) to the carrier and peaking amplifier paths 450, 470, and to the output terminals of the power transistor dies 454, 474. As mentioned previously, and according to one or more embodiments, each device 430, 530 also includes first and second conductive structures 437, 438 (e.g., each including one or more wirebonds) coupled between the first and second interior conductive structures 434, 436 (or the first and second output side bias leads 446, 447 or 546, 547) and first and second connection points (e.g., RF cold points) along the carrier and peaking amplifier paths 450, 470, respectively. For example, a first RF cold point may be present at the conductive bondpad at the top surface of IPD structure 458, or at another node within the carrier output matching network, and a second RF cold point may be present at the conductive bondpad at the top surface of IPD structure 478, or at another node within the peaking output matching network. As discussed previously, some or all of the output DC bias voltages may be conveyed from the bias-conducting structures 433, 435, 533, 535 through the first and second conductive structures 437, 438 to the conductive bondpads of the IPD structures 438, 458. The output DC bias voltages, thereafter, may be conveyed to the output terminals of the transistors within dies 454, 474 through the wirebonds 459 that extend between the IPD structures 438, 458 and the output terminals of the dies 454, 474.

In the embodiments illustrated in FIGs 4 and 5, additional output DC bias voltage conduction paths, in the form of conductive paths 483, 486 (e.g., conductive paths 183, 186, 283, 286, FIGs 1-3), are included on the output portion (e.g., portion 108, FIG. 1) of the transmitter substrate 410 to carry some or all of the DC current associated with the output DC bias voltages. More specifically, as discussed above, the first and second output side bias leads 446, 447, 546, 547 are physically and electrically coupled to the conductive paths 483, 486 on the output portion of the transmitter substrate 410, which in turn are coupled to the first and second output side signal leads 444, 445 through the conductive pads 460, 461.

As also discussed above, the Doherty power amplifier may include additional circuitry along the output DC bias voltage conduction paths that provide for decoupling in the DC and RF frequency domains. For example, DC decoupling capacitors 484, 487 (e.g., capacitors 184, 187, FIG. 1) and RF decoupling capacitors 485, 488 (e.g., capacitors 185, 188, FIG. 1) may be coupled in shunt configurations along the conductive paths 483, 486 between the output side bias leads 446, 447 and the first and second output side bias leads 446, 447, 546, 547. According to one or more embodiments, the electrical lengths of portions of the conductive paths 483, 486 between the connection point 463, 465 with the conductive pads 460, 461 and the RF decoupling capacitors 484, 487 (at connection points 462, 464) may be designed to be about 90 degrees (i.e., a quarter wavelength at the fundamental frequency, *ƒ₀*), which emulates open circuits at the connection points 463, 465 between the conductive pads 460, 461 and the conductive paths 483, 486. The capacitance values of the RF decoupling capacitors 484, 487 essentially produce a short circuit at the fundamental frequency, *ƒ₀*. Accordingly, this configuration restricts RF signal energy from being conveyed through the conductive paths 483, 486 and input-to-output bias-conducting structures 433, 435, 533, 535 to the output bias voltage power supplies (e.g., supplies 104, 106, FIG. 1).

By way of a summary of the output DC bias voltage conduction paths for the embodiments of FIGs 4 and 5, a first output DC bias voltage conduction path (for the carrier amplifier transistor output bias voltage) includes a power supply terminal (e.g., terminal 115, 215, FIGs 1-3), a conductive trace (e.g., trace 315, FIGs 2, 3) on the input portion of the transmitter substrate, an input-to-output bias-conducting structure 433, 533, a first conductive structure 437, and a conductive path 483. A second output DC bias voltage conduction path (for the peaking amplifier transistor output bias voltage) includes a power supply terminal (e.g., terminal 117, 217, FIGs 1-3), a conductive trace (e.g., trace 317, FIGs 2, 3) on the input portion of the transmitter substrate, an input-to-output bias-conducting structure 435, 535, a second conductive structure 438, and a conductive path 486.

It should be understood that devices 430, 530 and the circuitry on the transmitter substrate 410 may be incorporated into the physical embodiments of transmitter substrates shown in FIGs 2 and 3. Therefore, all of the circuitry shown in the embodiments of FIGs 2 and 3 may be utilized in conjunction with the device and circuitry embodiments shown in FIGs 4 and 5.

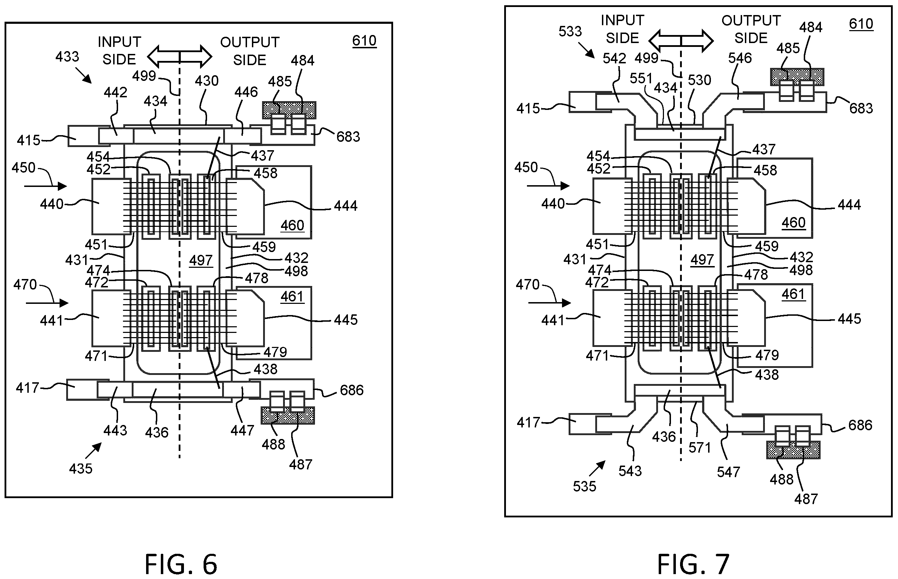

In some embodiments, the first and second conductive structures 437, 438 are capable of handling an entirety of the DC current associated with the output bias voltages (e.g., up to 10 amps), and accordingly, the conductive paths 483, 486 may be excluded. For example, FIGs 6 and 7 are top views of the embodiments of power amplifier devices 430, 530 of FIGs 4 and 5, which are coupled to a transmitter platform 610 that does not include the conductive paths 483, 486 (FIGs 4, 5). Instead of including conductive paths 483, 486 (FIGs 4, 5), in the embodiments of FIGs 6 and 7, the output side bias leads 446, 447, 546, 547 of the input-to-output bias-conducting structures 433, 435, 533, 535 may be physically and electrically coupled to conductive paths 683, 686 that extend only to the above-described DC decoupling capacitors 484, 487 (e.g., capacitors 184, 187, FIG. 1) and RF decoupling capacitors 485, 488 (e.g., capacitors 185, 188, FIG. 1).

More specifically, for the embodiments of FIGs 6 and 7, a first output DC bias voltage conduction path (for the carrier amplifier transistor output bias voltage) includes a power supply terminal (e.g., terminal 115, 215, FIGs 1-3), a conductive trace (e.g., trace 315, FIGs 2, 3) on the input portion of the transmitter substrate, an input-to-output bias-conducting structure 433, 533, and a first conductive structure 437. A second output DC bias voltage conduction path (for the peaking amplifier transistor output bias voltage) includes a power supply terminal (e.g., terminal 117, 217, FIGs 1-3), a conductive trace (e.g., trace 317, FIGs 2, 3) on the input portion of the transmitter substrate, an input-to-output bias-conducting structure 435, 535, and a second conductive structure 438.

Although not repeated here, all of the details regarding same-numbered elements that were described in conjunction with the description of the embodiments of FIGs 4 and 5 are incorporated herein for the description of the embodiments of FIGs 6 and 7. Further, it should be understood that devices 430, 530 and the circuitry on the transmitter substrate 610 may be incorporated into the physical embodiments of transmitter substrates shown in FIGs 2 and 3. Therefore, all of the circuitry shown in the embodiments of FIGs 2 and 3 may be utilized in conjunction with the device and circuitry embodiments shown in FIGs 6 and 7.

In the embodiments of FIGs 4-7, the DC decoupling capacitors 484, 487 (e.g., capacitors 184, 187, FIG. 1) and the RF decoupling capacitors 485, 488 (e.g., capacitors 185, 188, FIG. 1) are coupled to the output portion (e.g., portion 108, FIG. 1) of the transmitter substrate 410, 610. In still other embodiments, the DC decoupling capacitors 484, 487 (e.g., capacitors 184, 187, FIG. 1) and RF decoupling capacitors 485, 488 (e.g., capacitors 185, 188, FIG. 1) instead may be coupled to the input portion (e.g., portion 107, FIG. 1) of a transmitter substrate. Coupling the decoupling capacitors 484, 485, 487, 488 to the input portion of a transmitter substrate may be desirable to enable reductions in the size of the output portion of the transmitter substrate. In addition, in some embodiments, a power amplifier device may include features of a distinct VBW circuit.

For example, FIGs 8 and 9 are top views of embodiments of power amplifier devices 430', 530', which are coupled to a transmitter platform 810 that includes DC decoupling capacitors 484, 487 (e.g., capacitors 184, 187, FIG. 1) and RF decoupling capacitors 485, 488 (e.g., capacitors 185, 188, FIG. 1) that are coupled to the input portion of a transmitter substrate 810. In addition, as will be explained in detail below, the power amplifier devices 430', 530' each include features of a distinct VBW circuit 889.

In the embodiments shown in FIGs 8 and 9, power amplifier devices 430', 530' may be substantially the same as power amplifier devices 430, 530 (FIGs 4-7), respectively, except that power amplifier devices 430', 530' do not include conductive structures 437, 438, and instead, each device 430', 530' includes features associated with a VBW circuit 889 (e.g., VBW circuit 189, FIG. 1). As discussed previously, a VBW circuit may function to improve the low frequency resonance (LFR) of the Doherty power amplifier, which may be caused by the interaction with the bias feeds.

More specifically, each VBW circuit 889 includes conductive structures 437', 438' (e.g., wirebonds) within device 430', 530' that are coupled between the carrier and peaking amplifier paths 450, 470 (e.g., at RF cold points) and an additional output side lead 448 (e.g., lead 148, FIG. 1) of the device 430', 530'. The additional output side lead 448 may be positioned between (and spaced apart from) the first and second output side signal leads 444, 445, for example. The VBW circuit 889 also includes a conductive pad 462 on the transmitter substrate 810, and a capacitor 849 (e.g., capacitor 149, FIG. 1) on the transmitter substrate 810. The capacitor 849 has a first terminal coupled to the conductive pad 462, and a second terminal coupled to a ground reference node on the transmitter substrate 810.

In the embodiments of FIGs 8 and 9, a first output DC bias voltage conduction path (for the carrier amplifier transistor output bias voltage) includes a power supply terminal (e.g., terminal 115, 215, FIGs 1-3), a conductive trace 415 on the input portion of the transmitter substrate 810, an input-to-output bias-conducting structure 433, 533, and a conductive path 883 on the output portion of the transmitter substrate 810. A second output DC bias voltage conduction path (for the peaking amplifier transistor output bias voltage) includes a power supply terminal (e.g., terminal 117, 217, FIGs 1-3), a conductive trace 417 on the input portion of the transmitter substrate, an input-to-output bias-conducting structure 435, 535, and a conductive path 886 on the output portion of the transmitter substrate 810.

As indicated above, the embodiments illustrated in FIGs 8 and 9 also include additional circuitry along the output DC bias voltage conduction paths that provide for decoupling in the DC and RF frequency domains. For example, the additional circuitry may include DC decoupling capacitors 484, 487 (e.g., capacitors 184, 187, FIG. 1) and RF decoupling capacitors 485, 488 (e.g., capacitors 185, 188, FIG. 1). In contrast with the previously-described embodiments, however, the DC decoupling capacitors 484, 487 and RF decoupling capacitors 485, 488 are coupled in shunt configurations along the conductive paths 415, 417 between the bias voltage terminals 115, 117 (FIG. 1) and the input side bias leads 442, 443, 542, 543, rather than being coupled to the output portion of the transmitter substrate.

According to one or more embodiments, the electrical lengths of portions of the output DC bias voltage conduction paths that extend between the connection point 863, 865 with the conductive pads 460, 461 and the RF decoupling capacitors 484, 487 (at connection points 862, 864) is about 90 degrees (i.e., a quarter wavelength at the fundamental frequency, *ƒ₀*), which emulates an open circuit at the connection points 863, 865. Again, the capacitance value of the RF decoupling capacitors 484, 487 essentially produces a short circuit at the fundamental frequency, *ƒ₀*. This configuration restricts RF signal energy from being conveyed to the output bias voltage power supplies (e.g., supplies 104, 106, FIG. 1).

Although not repeated here, all of the details regarding same-numbered elements that were described in conjunction with the description of the embodiments of FIGs 4 and 5 are incorporated herein for the description of the embodiments of FIGs 8 and 9. Further, it should be understood that devices 430', 530' and the circuitry on the transmitter substrate 810 may be incorporated into the physical embodiments of transmitter substrates shown in FIGs 2 and 3. Therefore, all of the circuitry shown in the embodiments of FIGs 2 and 3 may be utilized in conjunction with the device and circuitry embodiments shown in FIGs 8 and 9.

Each embodiment of an input-to-output bias-conducting structure 133, 135, 433, 435, 533, 535 (FIGs 1, 4-9) described herein essentially is an electrically conductive element or assembly that enables a bias voltage to be conveyed from an input portion of a transmitter substrate (e.g., portion 107, FIG. 1) to an output portion of a transmitter substrate (e.g., portion 108, FIG. 1) through a power amplifier device (e.g., any of devices 130, 230, 330, 430, 430', 530, 530', FIGs 1-9). Said another way, each input-to-output bias-conducting structure 133, 135, 433, 435, 533, 535 (FIGs 1, 4-9) is a conductive element or assembly that enables a bias voltage to be conveyed from an input side of a power amplifier device (e.g., input side 131, 231, 331, 431, 531, FIGs 1-9) to an output side of the power amplifier device (e.g., output side 132, 232, 332, 432, 532, FIGs 1-9) through the power amplifier device itself.

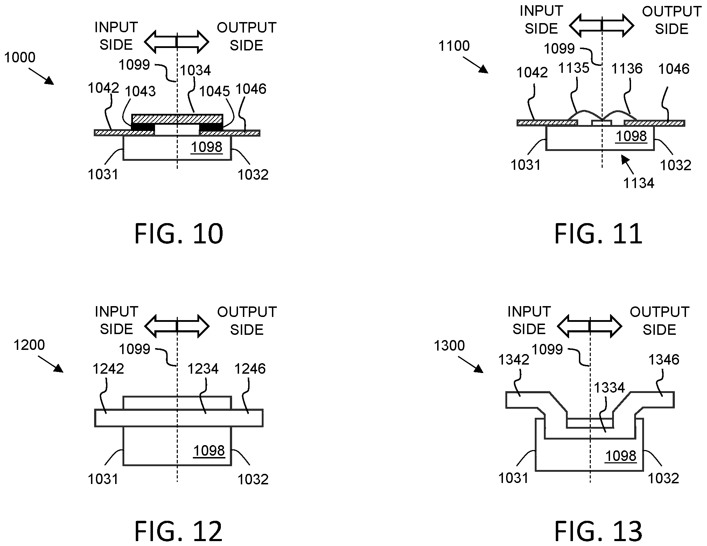

The input-to-output bias-conducting structures 133, 135, 433, 435, 533, 535 (FIGs 1, 4-9) described herein may have any of a number of physical configurations, and some non-limiting example configurations are shown in FIGs 10-13. For example, FIG. 10 is a side-cross sectional view of a first embodiment of an input-to-output bias-conducting structure 1000 (e.g., any of structures 133, 135, 433, 435, 533, 535, FIGs 1, 4-9), which is coupled to a non-conductive portion of a device substrate 1098 (e.g., a portion of an isolation structure or a section of non-conductive encapsulant material). The device substrate 1098 generally has an input side 1031 (e.g., input side 131, 231, 331, 431, FIGs 1-9) and an output side 1032 (e.g., output side 132, 232, 332, 432, FIGs 1-9). An input portion of the device substrate 1098 is defined between a bisection line 1099 and the input side 1031, and an output portion of the device substrate 1098 is defined between the bisection line 1099 and the output side 1032.

The input-to-output bias-conducting structure 1000 includes multiple distinct and rigid conductive structures 1034, 1042, and 1046 that are physically and electrically connected together with a conductive attachment material 1043, 1045 (e.g., solder, conductive epoxy, brazing, sintered conductive material, and so on), resulting in a continuous electrically conductive structure that extends from the input side 1031 (and input portion) of the device substrate 1098 to the output side 1032 (and output portion) of the device substrate 1098.

More particularly, the input-to-output bias-conducting structure 1000 includes an interior conductive structure 1034 (e.g., structure 134, 136, 434, 436, FIGs 1, 4-9) that transcends the bisection line 1099, an input side bias lead 1042 (e.g., lead 142, 143, 242, 243, 342, 343, 442, 443, 542, 543, FIGs 1-9) connected to a first end of the interior conductive structure 1034, and an output side bias lead 1046 (e.g., lead 146, 147, 246, 247, 346, 347, 446, 447, 546, 547, FIGs 1-9) connected to a second end of the interior conductive structure 1034. The bias leads 1042, 1046 may be "straight" (e.g., as shown in FIGs 2, 4, 6, and 8) or they may be "insect-type" (e.g., as shown in FIGs 3, 5, 7, and 9). Each of the bias leads 1042, 1046 and the interior conductive structure 1034 is formed from an electrically conductive material (e.g., copper or another suitable conductor), which is capable of reliably conveying relatively high bias currents (e.g., 10 amps or more).

FIG. 11 is a side-cross sectional view of a second embodiment of an input-to-output bias-conducting structure 1100 (e.g., any of structures 133, 135, 433, 435, 533, 535, FIGs 1, 4-9) coupled to a non-conductive portion of a device substrate 1098 (e.g., similar or identical to device substrate 1098 described in conjunction with FIG. 10). The input-to-output bias-conducting structure 1100 includes an input side bias lead 1142 (e.g., lead 142, 143, 242, 243, 342, 343, 442, 443, 542, 543, FIGs 1-9) at the input side 1031 of the substrate 1098, and an output side bias lead 1146 (e.g., lead 146, 147, 246, 247, 346, 347, 446, 447, 546, 547, FIGs 1-9) at the output side 1032 of the substrate 1098. In addition, the input-to-output bias-conducting structure 1100 includes an interior conductive structure 1134 (e.g., a substitute for any of structures 134, 136, 434, 436, FIGs 1, 4-9) that transcends the bisection line 1099, and that includes one or more wirebonds 1135, 1136 connected in series and/or parallel between the input side bias lead 1142 and the output side bias lead 1146.

Again, the bias leads 1142, 1146 may be "straight" (e.g., as shown in FIGs 2, 4, 6, and 8) or they may be "insect-type" (e.g., as shown in FIGs 3, 5, 7, and 9). Each of the bias leads 1142, 1146 and the wirebonds 1135, 1136 of the interior conductive structure 1134 is formed from an electrically conductive material (e.g., copper or another suitable conductor), which is capable of reliably conveying relatively high bias currents (e.g., 10 amps or more).

FIG. 12 is a top view of a third embodiment of an input-to-output bias-conducting structure 1200 (e.g., any of structures 133, 135, 433, 435, FIGs 1, 4, 6, 8) coupled to a non-conductive portion of a device substrate 1098 (e.g., similar or identical to device substrate 1098 described in conjunction with FIG. 10). The input-to-output bias-conducting structure 1200 includes a straight input side bias lead 1242 e.g., lead 142, 143, 242, 243, 442, 443, FIGs 1, 2, 4, 6, 8) at the input side 1031 of the substrate 1098, a straight output side bias lead 1246 (e.g., lead 146, 147, 246, 247, 446, 447, FIGs 1, 2, 4, 6, 8) at the output side 1032 of the substrate 1098, and an interior conductive structure 1234 (e.g., structure 134, 136, 434, 436, FIGs 1, 4, 6, 8) that transcends the bisection line 1099. In the embodiment of FIG. 12, the input side bias lead 1242, the interior conductive structure 1234, and the output side bias lead 1246 are integrally-formed together as a single article (e.g., a single piece of copper or other conductive material). In other words, the input side bias lead 1242, the interior conductive structure 1234, and the output side bias lead 1246 are integral portions of the input-to-output bias-conducting structure 1200.

Finally, FIG. 13 is a top view of yet another embodiment of an input-to-output bias-conducting structure 1300 (e.g., any of structures 133, 135, 533, 535, FIGs 1, 5, 7, 9) coupled to a non-conductive portion of a device substrate 1098 (e.g., similar or identical to device substrate 1098 described in conjunction with FIG. 10). The input-to-output bias-conducting structure 1300 includes an insect-type input side bias lead 1342 (e.g., lead 142, 143, 342, 343, 542, 543, FIGs 1, 3, 5, 7, 9) at the input side 1031 of the substrate 1098, an insect-type output side bias lead 1346 (e.g., lead 146, 147, 346, 347, 546, 547, FIGs 1, 3, 5, 7, 9) at the output side 1032 of the substrate 1098, and an interior conductive structure 1334 (e.g., structure 134, 136, 434, 436, FIGs 1, 5, 7, 9) that transcends the bisection line 1099. In the embodiment of FIG. 13, the input side bias lead 1342, the interior conductive structure 1334, and the output side bias lead 1346 are integrally-formed together as a single article (e.g., a single piece of copper or other conductive material). In other words, the input side bias lead 1342, the interior conductive structure 1334, and the output side bias lead 1346 are integral portions of the input-to-output bias-conducting structure 1300.

An embodiment of a power amplifier device includes an input side, an output side opposite the input side, and a mounting surface between the input side and the output side. The power amplifier device has an input portion that extends from the input side to a bisection line between the input side and the output side, and an output portion that extends from the output side to the bisection line. The power amplifier device also includes a first power transistor die coupled to the mounting surface with an input terminal and an output terminal, a first input side signal lead extending from an interior of the power amplifier device beyond the input side, a first output side signal lead extending from the interior of the power amplifier device beyond the output side, and a first input-to-output bias-conducting structure that is not physically directly connected to the first input side signal lead or to the first output side signal lead. The first input side signal lead is electrically coupled to the input terminal of the first power transistor die, and the first output side signal lead is electrically coupled to the output terminal of the first power transistor die. The first input-to-output bias-conducting structure includes a first input side bias lead coupled to the input portion of the power amplifier device, a first output side bias lead coupled to the output portion of the power amplifier device, and a first interior conductive structure having a first end connected to the first input side bias lead, and a second end connected to the first output side bias lead.

According to one or more further embodiments, the power amplifier device also includes a first transverse side that extends between the input and output sides, and the first interior conductive structure is positioned between the mounting surface and the first transverse side of the power amplifier device.

An embodiment of a transmitter platform includes a transmitter substrate with an input side, an output side opposite the input side, and a transmitter substrate mounting surface that extends between the input side of the transmitter substrate and the output side of the transmitter substrate. The transmitter substrate has an input portion that extends from the input side of the transmitter substrate to a bisection line between the input side and the output side, and an output portion that extends from the output side of the transmitter substrate to the bisection line. The transmitter platform also includes a plurality of input terminals coupled to the input portion of the transmitter substrate, and the plurality of input terminals includes a signal input terminal and a bias voltage terminal. The transmitter platform also includes a power amplifier device coupled to the transmitter substrate mounting surface. An embodiment of the power amplifier device includes an input side, an output side opposite the input side, and a mounting surface between the input side and the output side. The power amplifier device has an input portion that extends from the input side to the bisection line, and an output portion that extends from the output side to the bisection line. The power amplifier device also includes a power transistor die coupled to the mounting surface with an input terminal and an output terminal, an input side signal lead extending from an interior of the power amplifier device beyond the input side, an output side signal lead extending from the interior of the power amplifier device beyond the output side, and an input-to-output bias-conducting structure that is not physically directly connected to the input side signal lead or to the output side signal lead. The input side signal lead is electrically coupled to the input terminal of the power transistor die, and the output side signal lead is electrically coupled to the output terminal of the power transistor die. The input-to-output bias-conducting structure includes an input side bias lead coupled to the input portion of the power amplifier device, an output side bias lead coupled to the output portion of the power amplifier device, and an interior conductive structure having a first end connected to the input side bias lead, and a second end connected to the output side bias lead.

The preceding detailed description is merely illustrative in nature and is not intended to limit the embodiments of the subject matter or the application and uses of such embodiments. As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first," "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A power amplifier device (130, 230, 330, 430, 430', 530, 530') comprising:
an input side (131, 231, 331, 431, 1031), an output side (132, 232, 332, 432, 1032) opposite the input side, and a mounting surface (497) between the input side and the output side, wherein the power amplifier device has an input portion that extends from the input side to a bisection line (199, 299, 499, 1099) between the input side and the output side, and an output portion that extends from the output side to the bisection line;
a first power transistor die (154, 454) coupled to the mounting surface and having an input terminal (155) and an output terminal (156);
a first input side signal lead (140, 240, 440) extending from an interior of the power amplifier device beyond the input side, wherein the first input side signal lead is electrically coupled to the input terminal of the first power transistor die;
a first output side signal lead (144, 244, 444) extending from the interior of the power amplifier device beyond the output side, wherein the first output side signal lead is electrically coupled to the output terminal of the first power transistor die; and
a first input-to-output bias-conducting structure (133, 433, 533, 1000, 1100, 1200, 1300) that is not physically directly connected to the first input side signal lead or to the first output side signal lead, and wherein the first input-to-output bias-conducting structure includes
a first input side bias lead (142, 242, 342, 442, 542, 1042, 1242, 1342) coupled to the input portion of the power amplifier device,
a first output side bias lead (146, 246, 346, 446, 546, 1046, 1246, 1346) coupled to the output portion of the power amplifier device, and
a first interior conductive structure (134, 434, 1034, 1134, 1234, 1334) having a first end connected to the first input side bias lead, and a second end connected to the first output side bias lead.

2. The power amplifier device of claim 1, wherein:
the first input side bias lead, the first output side bias lead, and the conductive structure are distinct structures that are physically and electrically connected together to form the first input-to-output bias-conducting structure (133, 433, 1000, 1100).

3. The power amplifier device of claim 1, wherein:
the first input side bias lead, the first output side bias lead, and the conductive structure are integral portions of the first input-to-output bias-conducting structure (133, 433, 1200, 1300).

4. The power amplifier device of any preceding claim, wherein:
the power amplifier device further includes a first transverse side (351, 551) that extends between the input and output sides; and
the first interior conductive structure is positioned between the mounting surface and the first transverse side of the power amplifier device.

5. The power amplifier device of any preceding claim, wherein:
the first input side bias lead is a straight lead (242, 442, 1242) that extends perpendicularly from the input side; and
the first output side bias lead is a straight lead (246, 446, 1246) that extends perpendicularly from the output side.

6. The power amplifier device of any of claims 1 to 4, wherein:
the power amplifier device further includes a first transverse side (351, 551) that extends between the input and output sides;
the first input side bias lead is an insect-type lead (342, 542, 1342) that extends perpendicularly from the first transverse side; and
the first output side bias lead is an insect-type lead (346, 546, 1346) that extends perpendicularly from the first transverse side.

7. The power amplifier device of claim 6, wherein:
the first input side bias lead (342, 542, 1342) has a 90 degree bend and a portion that extends beyond the input side; and
the first output side bias lead (346, 546, 1346) has a 90 degree bend and a portion that extends beyond the output side.

8. The power amplifier device of any preceding claim, further comprising:
a conductive structure (137, 437) between the first input-to-output bias-conducting structure and the output terminal of the power transistor.

9. The power amplifier device of any preceding claim, further comprising:
a second power transistor die (174, 474) coupled to the mounting surface and having an input terminal (175) and an output terminal (176);
a second input side signal lead (141, 241, 441) extending from the interior of the power amplifier device beyond the input side, wherein the second input side signal lead is electrically coupled to the input terminal of the second power transistor die;
a second output side signal lead (144, 244, 444) extending from the interior of the power amplifier device beyond the output side, wherein the second output side signal lead is electrically coupled to the output terminal of the second power transistor die; and
a second input-to-output bias-conducting structure (135, 435, 535) that is not physically directly connected to the second input side signal lead or to the second output side signal lead, and wherein the second input-to-output bias-conducting structure includes
a second input side bias lead (143, 243, 343, 443, 543) coupled to the input portion of the power amplifier device,
a second output side bias lead (147, 247, 347, 447, 547) coupled to the output portion of the power amplifier device, and
a second interior conductive structure (136, 436) having a first end connected to the first input side bias lead, and a second end connected to the first output side bias lead.

10. The power amplifier device of claim 9, wherein the power amplifier device further comprises:
an additional output side lead (148, 448) between the first and second output side signal leads, which extends from the interior of the power amplifier device beyond the output side;
a first conductive structure (137', 437') between the additional output side lead and the output terminal of the first power transistor; and
a second conductive structure (138', 438') between the additional output side lead and the output terminal of the second power transistor.

11. A transmitter platform (100, 200, 300) comprising:
a transmitter substrate (110, 210, 310, 410) with an input side (111, 211), an output side (112, 212) opposite the input side, and a transmitter substrate mounting surface that extends between the input side of the transmitter substrate and the output side of the transmitter substrate, wherein the transmitter substrate has an input portion (107) that extends from the input side of the transmitter substrate to a bisection line (199, 299) between the input side and the output side, and an output portion (108) that extends from the output side of the transmitter substrate to the bisection line;
a plurality of input terminals (113, 114, 115, 116, 117, 118) coupled to the input portion of the transmitter substrate, wherein the plurality of input terminals includes a signal input terminal (113, 213) and a bias voltage terminal (115, 215);
a power amplifier device (130, 230, 330, 430, 430', 530, 530') as claimed in any preceding claim and coupled to the transmitter substrate mounting surface .

12. The transmitter platform of claim 11, further comprising:
a second conductive bias path (183, 283, 483, 883) coupled to the transmitter substrate and extending from the output side bias lead to the output side signal lead.

13. The transmitter platform of claim 11 or 12, wherein:
the input side bias lead is a straight lead (242, 442, 1242) that extends perpendicularly from the input side of the power amplifier device; and
the output side bias lead (246, 446, 1246) is a straight lead that extends perpendicularly from the output side of the power amplifier device.

14. The transmitter platform of any of claims 11 to 13, wherein:
the power amplifier device further includes a transverse side (351, 551) that extends between the input and output sides of the power amplifier device;
the input side bias lead is an insect-type lead (342, 542, 1342) that extends perpendicularly from the transverse side; and
the output side bias lead is an insect-type lead (346, 546, 1346) that extends perpendicularly from the transverse side.

15. The transmitter platform of any of claims 11 to 14, wherein:
the power amplifier device further includes
an additional output side lead (148, 448) , which extends from the interior of the power amplifier device beyond the output side of the power amplifier device, and
a conductive structure (137', 437') between the additional output side lead and the output terminal of the power transistor; and
the transmitter platform further includes a capacitor (149, 849) coupled to the transmitter substrate and electrically connected between the additional output side lead and a ground reference node.
